# EUROPEAN PATENT SPECIFICATION

(11) **EP 4 167 426 B1**
(45) Date of publication and mention of the grant of the patent: **24.07.2024**
(21) Application number: 22200463.2
(22) Date of filing: 10.10.2022
(51) Int. Cl.: H02J 7/00

(54) **BATTERY APPARATUS AND CONTROL METHOD THEREOF**
BATTERIEVORRICHTUNG UND STEUERUNGSVERFAHREN DAFÜR
APPAREIL DE BATTERIE ET SON PROCÉDÉ DE COMMANDE

(30) Priority: 13.10.2021 KR 20210135989
(43) Date of publication of application: 19.04.2023
(73) Proprietor: Samsung SDI Co., Ltd., Yongin-si, Gyeonggi-do 17084 (KR)
(72) Inventor: KIM, Taeho, Yongin-si (KR)
(74) Representative: Marks & Clerk LLP

(56) References cited:
- EP-A2- 2 806 525

## Description

### BACKGROUND OF THE INVENTION

### (a) Field of the Invention

The present disclosure relates to a battery apparatus and a control method thereof.

### (b) Description of the Related Art

A battery management system and a plurality of battery modules transmit and receive data through wires. The battery module performs an operation corresponding to an instruction of the battery management system. In most cases, the battery management system transmits one instruction and then disconnects the connection with the battery module so as to control another battery module.

However, an unpredictable connection failure between the battery management system and the battery module may occur. In this case, even if the connection between the battery management system and the battery module becomes normal, the battery management system cannot know which operation the battery module is performing.

The above information disclosed in this Background section is only for enhancement of understanding of the background of the invention, and therefore it may contain information that does not form the prior art that is already known in this country to a person of ordinary skill in the art.

EP 2 806 525 A2 discloses an apparatus comprising a plurality of battery packs each comprising a plurality of battery cells and a battery management system for controlling charge and discharge of the battery packs.

### SUMMARY OF THE INVENTION

Embodiments have been made in an effort to provide a battery apparatus according to claim 1 and a control method of a battery apparatus according to claim 5.

### BRIEF DESCRIPTION OF THE DRAWINGS

FIG. 1 illustrates a battery apparatus according to the present disclosure.
FIG. 2 illustrates a battery module and a battery management system of a battery apparatus according to the present disclosure in more detail.
FIG. 3 illustrates a mode and a task corresponding to the mode in a battery apparatus according to the present disclosure.
FIG. 4 illustrates an operation flowchart when a battery management system is connected to a battery module, in a battery apparatus according to the present disclosure.

### DETAILED DESCRIPTION OF THE EMBODIMENTS

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present invention may obscure the gist of the present invention, it will be omitted. Further, the accompanying drawings are provided only in order to allow embodiments disclosed in the present specification to be easily understood and are not to be interpreted as limiting the disclosure of the present specification, and it is to be understood that the present invention includes all modifications, equivalents, and substitutions without departing from the scope of the present invention as defined by the claims.

Terms including an ordinal number, such as first, second, etc., may be used to describe various elements, but the elements are not limited by the terms. The terms are only used to differentiate one constituent element from other constituent elements.

It should be understood that, when it is described that an element is "coupled" or "connected" to another element, the element may be "directly coupled" or "directly connected" to the another element, or may be "coupled" or "connected" to the other element through a third element. In contrast, it should be understood that, when it is described that an element is "directly coupled" or "directly connected" to another element, no element is present between the element and the other element.

In the present application, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

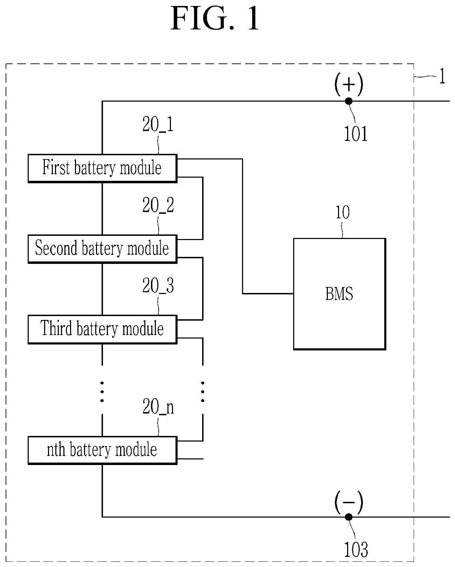

FIG. 1 illustrates a battery apparatus 1 according to the present disclosure.

The battery apparatus 1 includes a battery management system 10 and a plurality of battery modules 20_1 to 20_n.

The battery management system 10 and the plurality of battery modules 20_1 to 20_n may transmit and receive data through UART or CAN communication.

For example, the battery management system 10 may be connected to one battery module 20_i (i is one of natural numbers from 1 to n) of the plurality of battery modules 20_1 to 20_n to transmit a control signal for controlling an operation of the battery module 20_i to the battery module 20_i.

The plurality of battery modules 20_1 to 20_n are connected in series to supply desired power to connection terminals 101 and 103 of the battery apparatus 1.

The plurality of battery modules 20_1 to 20_n may be connected to the battery management system 10 through respective wires. FIG. 1 illustrates a case in which the first battery module 20_1 is connected to the battery management system 10. For example, the battery management system 10 and the plurality of battery modules 20_1 to 20_n may be connected by using a daisy chain method.

In addition, each battery module 20_i may transmit information on an operation state of the battery module 20_i to the battery management system 10.

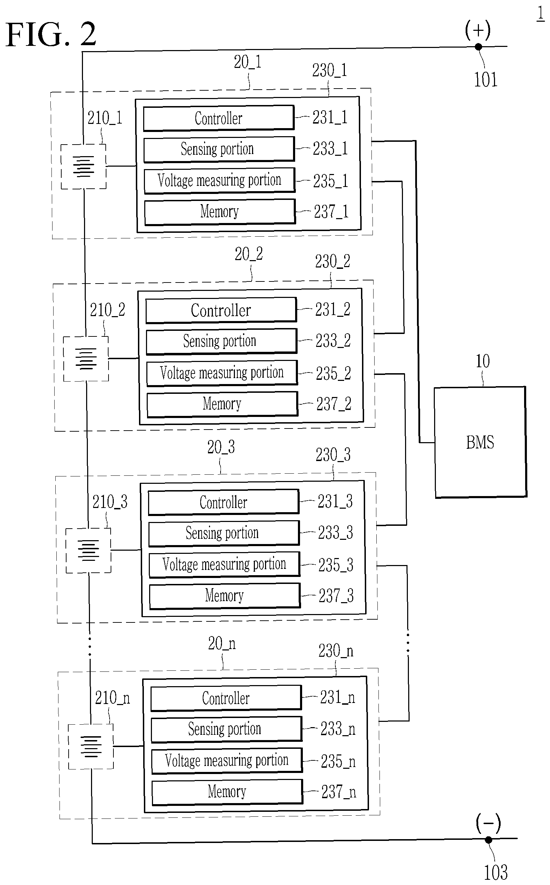

FIG. 2 illustrates the battery module 20_i and the battery management system 10 of the battery apparatus 1 according to the present disclosure in more detail.

The battery module 20_i may include a plurality of battery cells 210_i and a battery module manager (BMM) 230_i.

The plurality of battery cells 210_i may be rechargeable secondary batteries. The plurality of battery cells 21 0_i are connected in series to form the battery module 20_i.

The battery module manager 230_i may include a controller 231_i, a sensing portion 233_i that measures a temperature of the battery cell 210_i, a voltage measuring portion 235_i that measures a voltage of each of the battery cells 21 0_i, and a memory 237_i.

The controller 231_i may control overall constituent elements of the battery module 20_i to perform an operation corresponding to the control signal based on the control signal received from the battery management system 10.

The sensing portion 233_i may measure a cell temperature of each of the plurality of battery cells 210_i. The sensing portion 233_i may generate a voltage signal or a current signal indicating the measured cell temperature to transmit it to the controller 231_i.

The voltage measuring portion 235_i may measure a cell voltage of each of the plurality of battery cells 210_i. The voltage measuring portion 235_i may generate a voltage signal or a current signal indicating the measured cell voltage to transmit it to the controller 231_i.

The memory 237_i may include data required for the controller 231 to control the battery module 20_i. In addition, the memory 237_i may include operation information on an operation state currently being performed by the battery module 20_i. The operation information may include mode information and task information on a task to be performed or being performed by the battery module 20_i in each mode. Furthermore, the operation information may include information on the cell temperature measured by the sensing portion 233_i, the cell voltage measured by the voltage measuring portion 235_i, and the like.

The controller 231_i may transmit operation information of the battery module 20_i to the battery management system 10 according to a request of the battery management system 10.

The battery management system 10 may generate a control signal for controlling the battery module 20_i based on the operation information received from the battery module manager 230_i. Specifically, the battery management system 10 may generate the control signal based on mode information and task information, a cell voltage, and a cell temperature included in the operation information.

The control signal may include information on a mode to be performed in the future by the battery module 20_i and a task corresponding thereto. One mode may include a plurality of tasks whose order is predetermined. The battery management system 10 may determine an operation required for the battery module 20_i based on the operation information to generate a control signal corresponding thereto. Each mode and the task corresponding thereto may be stored in advance in the battery management system 10.

For example, the battery management system 10 may detect a cell requiring cell balancing based on a plurality of cell voltages included in the operation information, and may generate a control signal for performing a cell balancing operation.

Generally, the battery management system 10 may generate a control signal corresponding to each task so that each battery module 20_i performs operations included in any one mode. In addition, the battery management system 10 may transmit a control signal corresponding to each battery module 20_i.

When the battery module manager 230_i receives a corresponding control signal from the battery management system 10, as described above, the battery module manager 230_i may control the battery module 20_i to perform the task corresponding to the control signal.

The battery management system 10 and the battery module 20_i may be disconnected while the battery module 20_i is performing a task included in a mode corresponding to the control signal. In order for the battery module 20_i to proceed to a next task of the corresponding mode, it must receive a control signal corresponding to the next task from the battery management system 10. However, since the battery management system 10 and the battery module 20_i are disconnected, the battery module 20_i cannot receive a new control signal from the battery management system 10, so that it continuously performs the task corresponding to the control signal received directly before they are disconnected.

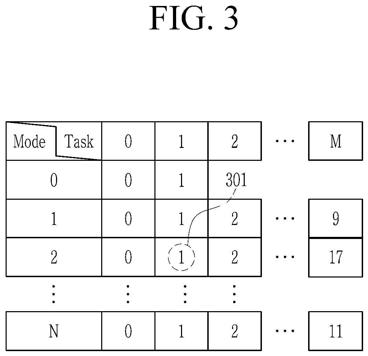

Hereinafter, mode information and task information included in operation information will be described with reference to FIG. 3.

FIG. 3 illustrates a mode and a task corresponding to the mode in the battery apparatus 1 according to the present disclosure.

As shown in FIG. 3, the battery apparatus 1 may operate in a plurality of modes. A plurality of modes includes a battery management system 10 initializing mode, a battery module manager 230_i initializing mode, a measurement mode, a diagnosis mode, a cell balancing mode, an error mode, and a default mode. In addition, there may be a mode in which the battery module manager 230_i performs emergency discharge of the battery cell 210_i for 10 seconds.

In addition, each mode may include M (M is a natural number) sequential tasks required to perform each mode.

The battery management system 10 initializing mode may include a task of initializing all data stored in the battery management system 10, and then a task of connecting the battery management system 10 and the battery module manager 230_i. For example, there may be a case in which a power source is connected to the battery management system 10.

The battery module manager 230_i initializing mode may include a task of initializing all data stored in the battery module manager 230_i. This may be performed while the battery management system 10 initializes all data stored in the battery management system 10 or during an arbitrary operation. For example, when the battery management system 10 detects an abnormal operation of the battery module manager 230_i, it may generate a control signal including the battery module manager 230_i initializing mode.

The measurement mode may include at least one of a task in which the sensing portion 233_i of the battery module manager 230_i measures a cell temperature and a task in which the voltage measuring portion 235_i measures a cell voltage.

The diagnosis mode may include a task in which the battery management system 10 checks whether there is an abnormality in a specific item set in advance in the battery module manager 230_i. For example, the diagnosis mode may include a charging pump confirmation task, a sensing portion confirmation task, a balancing switch confirmation task, an ADC confirmation task, and a communication data confirmation task.

The cell balancing mode may include a series of tasks required for cell balancing of the battery module 20_i.

The error mode may include a task performed by the battery management system 10 when an abnormality is detected during operation. For example, when the battery management system 10 detects deterioration in reliability of data collected from the battery module manager 230_i, an error may be detected in communication with the battery module manager 230_i.

The battery management system 10 may transmit a control signal for controlling the battery module 20_i to perform task 1 of mode 2 to the battery module 20_i. The battery module 20_i may perform an operation corresponding to task 1 of mode 2 based on the received control signal. Here, the operation corresponding to task 1 may be an operation of measuring a battery cell temperature or an operation of measuring a cell voltage.

The battery management system 10 may receive a report on completion of task 1 from the battery module 20_i, or may control the battery module 20_i to perform a next task after a predetermined time has elapsed from starting of task 1. That is, the battery management system 10 may generate a control signal for controlling to perform task 2 of mode 2 to transmit the generated control signal to the battery module 20_i. The battery module 20_i may perform an operation corresponding to task 2 of mode 2 based on the received control signal.

That is, when the battery management system 10 controls the battery module 20_i in mode 2, the battery management system 10 may generate 17 control signals to transmit them to the battery module 20_i so that the battery module 20_i performs up to an operation corresponding to task 17 of mode 2.

When the battery management system 10 and the battery module 20_i are disconnected, the battery module 20_i may repeatedly perform an operation corresponding to a control signal last received from the battery management system 10.

In this case, when the battery management system 10 and the battery module 20_i are connected again, the battery module 20_i may transmit operation information including task information and mode information corresponding to the operation being performed to the battery management system 10.

For example, when the battery management system 10 and the battery module 20_i are disconnected after the control signal for controlling the battery management system 10 to perform the operation corresponding to task 2 of mode 2 is transmitted to the battery module 20_i, the battery module 20_i may continuously perform the operation corresponding to task 2 of mode 2. Thereafter, when the battery management system 10 and the battery module 20_i are connected again, the battery module 20_i may transmit operation information including information on mode 2 and information on task 2 corresponding to the currently performed operation to the battery management system 10.

The battery management system 10 may confirm that the battery module 20_i performs the operation corresponding to task 2 of mode 2 based on operation information including information on mode 2 and information on task 2 based on the operation information of the battery module 20_i. Accordingly, the battery management system 10 may generate a control signal so that the battery module 20_i performs an operation corresponding to task 3, which is a next step of task 2 in mode 2. Accordingly, the continuity of the operation of the battery module 20_i may be maintained.

When the battery management system 10 and the battery module 20_i are disconnected after the control signal for controlling the battery management system 10 to perform mode 2 and task 17 is transmitted to the battery module 20_i, the battery module 20_i may continuously perform the operation corresponding to task 17 of mode 2. Thereafter, when the battery management system 10 and the battery module 20_i are connected again, the battery module 20_i may transmit operation information including information on mode 2 and information on task 17 to the battery management system 10. However, as shown in FIG. 3, there is no next task of task 17 in mode 2. Accordingly, the battery management system 10 may generate a control signal for controlling to perform task 0, which is the first task of the corresponding mode, rather than a control signal for performing the next task of the operation being performed. Thereafter, the battery module 20_i may perform an operation corresponding to task 0 of mode 2.

When the battery module 20_i is performing no operation, the battery module 20_i may transmit operation information including mode information on the default mode (for example, mode 0) indicating that the battery module is not operating in any mode to the battery management system 10. Accordingly, the battery management system 10 may determine that the battery module 20_i is performing no operation, determine the operation required for the battery module 20_i, and generate a control signal corresponding thereto.

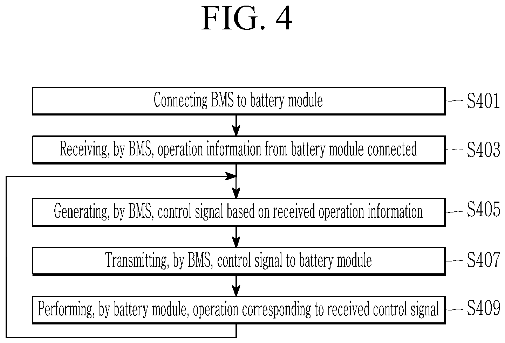

FIG. 4 illustrates an operation flowchart when the battery management system 10 is connected to the battery module 20_i, in the battery apparatus 1 according to the present disclosure.

First, the battery management system 10 is connected to the battery module 20_i (S401).

The battery management system 10 and the battery module 20_i may be connected through a wire. The battery management system 10 and the battery module 20_i may transmit and receive data through UART communication or CAN communication.

The battery management system 10 receives operation information of the battery module 20_i from the battery module 20_i connected thereto (S403).

The operation information is information on an operation state being performed by the battery module 20_i, and may include mode information and task information about a task to be performed or being performed by the battery module 20_i in each mode. Furthermore, the operation information may include information about a temperature of the battery cell 210_i in the battery module 20_i, a voltage of the battery cell 210_i, and the like. One mode may include a plurality of tasks of which order is predetermined.

The battery management system 10 generates a control signal based on the received operation information (S405).

The battery management system 10 may determine which operation the battery module 20_i is performing, and generate control signals corresponding to respective tasks to sequentially perform tasks included in the corresponding mode.

Alternatively, the battery management system 10, when there is no next operation to be performed by the battery module 20_i in the mode corresponding to the mode information, may generate a control signal for controlling to perform the first operation of the corresponding mode.

The battery management system 10, when the operation information including the information on mode 0 is received from the battery module 20_i, may determine that the battery module 20_i is performing no operation. Next, the battery management system 10 may determine a task required for the battery module 20_i based on the operation information including information on the temperature of the battery cell 210_i in the battery module 20_i, the voltage of the battery cell 210_i, and the like, and may generate a control signal that controls to perform the corresponding task.

The battery management system 10 transmits a control signal to the battery module 20_i (S407).

The battery module 20_i performs an operation corresponding to the received control signal (S409).

According to the battery apparatus according to the present disclosure, even in a case of an unexpected connection failure between the battery management system and the battery module, it is possible to control the battery module to continuously perform the operation.

According to the battery apparatus according to the present disclosure, the battery management system may be configured in the method in which it transmits only the control signal required to the battery module, disconnects the connection, and controls other battery modules, so that it is possible to control a plurality of battery modules by a small number of battery management systems.

The steps constituting the method according to the embodiments may be performed in an appropriate order unless explicitly stated or contradicted by the order. The present invention is not necessarily limited to the described order of steps. In the present invention, use of all examples or illustrative terms (e.g., etc.) is merely for describing the present invention in detail, and thus the scope of the present invention is not limited thereto. In addition, a person of ordinary skill in the art can recognize that various modifications, combinations, and changes may be made within the scope of the claims.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A battery apparatus comprising:
a battery module including a plurality of battery cells; and
a battery management system configured to:
receive from the battery module operation information including mode information and task information about an operation being performed by the battery module
generate a control signal with respect to the battery module based on the operation information; and
transmit the control signal to the battery module connected thereto, wherein at least one mode includes a plurality of tasks of which order is predetermined, wherein,
when determining that there is a next task of the task corresponding to the task information in a mode corresponding to the mode information, the battery management system is configured to generate a control signal controlling the battery module so that the battery module performs the next task.

2. The battery apparatus of claim 1, wherein
the operation information further includes information about at least one of a temperature and a voltage of a battery cell of each of the battery modules, and
when the mode information indicates a default mode indicating that there is no operation being performed by the battery module, the battery management system is configured to generate a control signal based on the information about at least one of the temperature and the voltage of each battery cell.

3. The battery apparatus of claim 1 or 2 wherein
when determining that there is no next task of the task corresponding to the task information in a mode corresponding to the mode information, the battery management system is configured to generate a control signal controlling the battery module so that the battery module performs a first task of the mode.

4. The battery apparatus of any one of claims 1 to 3, wherein
the mode includes at least one of a battery management system initializing mode, a battery module manager initializing mode, a measurement mode, a diagnosis mode, a cell balancing mode, an error mode, and a default mode.

5. A control method of a battery apparatus, comprising:
transmitting, by a battery module including a plurality of battery cells, operation information on an operation being performed to a battery management system, wherein the operation information includes mode information and task information, and at least one mode includes a plurality of operations of which order is predetermined;
generating, by the battery management system, a control signal with respect to the battery module based on the operation information; and transmitting, by the battery management system, the control signal to the battery module, wherein
the generating of the control signal includes
generating, by the battery management system, when determining that there is a next task of the task corresponding to the task information in a mode corresponding to the mode information, a control signal controlling the battery module so that the battery module performs the next task.

6. The control method of the battery apparatus of claim 5, wherein
the operation information further includes information about at least one of a temperature and a voltage of a battery cell of each of the battery modules,
the transmitting of the operation information to the battery management system includes
transmitting, by the battery module, operation information including mode information indicating a default mode indicating that there is no operation being performed by the battery module, to the battery management system, and
the generating of the control signal includes
generating, by the battery management system, a control signal based on information on at least one of a temperature and a voltage of each of the battery cells when the mode information indicates the default mode.

7. The control method of the battery apparatus of claim 5 or 6 , wherein
the generating of the control signal includes
generating, by the battery management system, when determining that there is no next task of the task corresponding to the task information in a mode corresponding to the mode information, a control signal controlling the battery module so that the battery module performs a first task of the mode.

8. The control method of the battery apparatus of any one of claims 5 to 7, wherein
the mode includes at least one of a battery management system initializing mode, a battery module manager initializing mode, a measurement mode, a diagnosis mode, a cell balancing mode, an error mode, and a default mode.

## Patentansprüche

1. Batterievorrichtung, die Folgendes umfasst:
ein Batteriemodul, das eine Vielzahl von Batteriezellen einschließt; und
ein Batteriemanagementsystem, konfiguriert zum:
Empfangen von Vorgangsinformationen von dem Batteriemodul, die Modusinformationen und Aufgabeninformationen über einen von dem Batteriemodul durchgeführten Vorgang einschließen,
Erzeugen eines Steuersignals in Bezug auf das Batteriemodul auf der Basis der Vorgangsinformationen; und
Übertragen des Steuersignals an das damit verbundene Batteriemodul, wobei mindestens ein Modus eine Vielzahl von Aufgaben einschließt, deren Reihenfolge vorbestimmt ist, wobei
das Batteriemanagementsystem, wenn es feststellt, dass es eine nächste Aufgabe der Aufgabe gibt, die den Aufgabeninformationen in einem Modus entsprechend den Modusinformationen entspricht, zum Erzeugen eines Steuersignals konfiguriert ist, das das Batteriemodul so steuert, dass das Batteriemodul die nächste Aufgabe durchführt.

2. Batterievorrichtung nach Anspruch 1, wobei
die Vorgangsinformationen ferner Informationen über mindestens eine von einer Temperatur und einer Spannung einer Batteriezelle jedes der Batteriemodule einschließen, und
das Batteriemanagementsystem, wenn die Modusinformationen einen Standardmodus angeben, der angibt, dass kein Vorgang vom Batteriemodul durchgeführt wird, zum Erzeugen eines Steuersignals auf der Basis der Informationen über mindestens eine von der Temperatur und der Spannung jeder Batteriezelle konfiguriert ist.

3. Batterievorrichtung nach Anspruch 1 oder 2, wobei
das Batteriemanagementsystem, wenn es feststellt, dass es in einem Modus entsprechend den Modusinformationen keine nächste Aufgabe der Aufgabe entsprechend den Aufgabeninformationen gibt, zum Erzeugen eines Steuersignals konfiguriert ist, das das Batteriemodul so steuert, dass das Batteriemodul eine erste Aufgabe des Modus durchführt.

4. Batterievorrichtung nach einem der Ansprüche 1 bis 3, wobei
der Modus mindestens einen von einem Initialisierungsmodus des Batteriemanagementsystems, einem Initialisierungsmodus des Batteriemodulmanagers, einem Messmodus, einem Diagnosemodus, einem Zellenausgleichsmodus, einem Fehlermodus und einem Standardmodus einschließt.

5. Steuerungsverfahren für eine Batterievorrichtung, das Folgendes umfasst:
Übertragen, durch ein Batteriemodul, das eine Vielzahl von Batteriezellen einschließt, von Vorgangsinformationen über einen durchgeführten Vorgang an ein Batteriemanagementsystem, wobei die Vorgangsinformationen Modusinformationen und Aufgabeninformationen einschließen, und mindestens ein Modus eine Vielzahl von Vorgängen einschließt, deren Reihenfolge vorbestimmt ist;
Erzeugen, durch das Batteriemanagementsystem, eines Steuersignals in Bezug auf das Batteriemodul auf der Basis der Vorgangsinformationen; und
Übertragen, durch das Batteriemanagementsystem, des Steuersignals an das Batteriemodul, wobei
das Erzeugen des Steuersignals Folgendes einschließt:
Erzeugen, durch das Batteriemanagementsystem, wenn es feststellt, dass es eine nächste Aufgabe der Aufgabe gibt, die den Aufgabeninformationen in einem Modus entsprechend den Modusinformationen entspricht, eines Steuersignals, das das Batteriemodul so steuert, dass das Batteriemodul die nächste Aufgabe durchführt.

6. Steuerverfahren für die Batterievorrichtung nach Anspruch 5, wobei
die Vorgangsinformationen ferner Informationen über mindestens eine von einer Temperatur und einer Spannung einer Batteriezelle jedes der Batteriemodule einschließen,
das Übertragen der Vorgangsinformationen an das Batteriemanagementsystem Folgendes einschließt:
Übertragen, durch das Batteriemodul, von Vorgangsinformationen einschließlich Modusinformationen, die einen Standardmodus angeben, der angibt, dass kein Vorgang von dem Batteriemodul durchgeführt wird, an das Batteriemanagementsystem, und
das Erzeugen des Steuersignals Folgendes einschließt:
Erzeugen, durch das Batteriemanagementsystem, eines Steuersignals auf der Basis von Informationen über mindestens eine von einer Temperatur und einer Spannung jeder der Batteriezellen, wenn die Modusinformationen den Standardmodus angeben.

7. Steuerverfahren für die Batterievorrichtung nach Anspruch 5 oder 6, wobei
das Erzeugen des Steuersignals Folgendes einschließt:
Erzeugen, durch das Batteriemanagementsystem, wenn es feststellt, dass es keine nächste Aufgabe der Aufgabe gibt, die den Aufgabeninformationen in einem Modus entsprechend den Modusinformationen entspricht, eines Steuersignals, das das Batteriemodul so steuert, dass das Batteriemodul eine erste Aufgabe des Modus durchführt.

8. Steuerverfahren für die Batterievorrichtung nach einem der Ansprüche 5 bis 7, wobei
der Modus mindestens einen von einem Initialisierungsmodus des Batteriemanagementsystems, einem Initialisierungsmodus des Batteriemodulmanagers, einem Messmodus, einem Diagnosemodus, einem Zellenausgleichsmodus, einem Fehlermodus und einem Standardmodus einschließt.

## Revendications

1. Appareil à batterie comprenant :
un module de batterie incluant une pluralité de cellules de batterie ; et
un système de gestion de batterie configuré pour :
recevoir du module de batterie des informations d'opération incluant des informations de mode et des informations de tâche, concernant une opération effectuée par le module de batterie
générer un signal de commande concernant le module de batterie sur la base des informations d'opération ; et
transmettre le signal de commande au module de batterie connecté à celui-ci, dans lequel au moins un mode inclut une pluralité de tâches dont l'ordre est prédéterminé, dans lequel,
lorsqu'il détermine qu'il existe une tâche suivante de la tâche correspondant aux informations de tâche dans un mode correspondant aux informations de mode, le système de gestion de batterie est configuré pour générer un signal de commande commandant le module de batterie de sorte que le module de batterie effectue la tâche suivante.

2. Appareil à batterie selon la revendication 1, dans lequel
les informations d'opération incluent en outre des informations sur au moins l'une d'une température et d'une tension d'une cellule de batterie de chacun des modules de batterie, et
lorsque les informations de mode indiquent un mode par défaut indiquant qu'aucune opération n'est effectuée par le module de batterie, le système de gestion de batterie est configuré pour générer un signal de commande sur la base des informations concernant au moins l'une de la température et de la tension de chaque cellule de batterie.

3. Appareil à batterie selon la revendication 1 ou 2, dans lequel
lorsqu'il détermine qu'il n'existe pas de tâche suivante pour la tâche correspondant aux informations de tâche dans un mode correspondant aux informations de mode, le système de gestion de batterie est configuré pour générer un signal de commande commandant le module de batterie de sorte que le module de batterie effectue une première tâche du mode.

4. Appareil à batterie selon l'une quelconque des revendications 1 à 3, dans lequel
le mode inclut au moins l'un d'un mode d'initialisation du système de gestion de batterie, d'un mode d'initialisation du gestionnaire de module de batterie, d'un mode de mesure, d'un mode de diagnostic, d'un mode d'équilibrage des cellules, d'un mode d'erreur et d'un mode par défaut.

5. Procédé de commande d'un appareil à batterie, comprenant les étapes consistant à :
transmettre, par un module de batterie incluant une pluralité de cellules de batterie, des informations d'opération sur une opération en cours d'exécution à un système de gestion de batterie, dans lequel les informations d'opération incluent des informations de mode et des informations de tâche, et au moins un mode inclut une pluralité d'opérations dont l'ordre est prédéterminé ;
générer, par le système de gestion de batterie, un signal de commande relatif au module de batterie sur la base des informations d'opération ; et
transmettre, par le système de gestion de batterie, le signal de commande au module de batterie, dans lequel
la génération du signal de commande inclut
la génération, par le système de gestion de batterie, lorsqu'il détermine qu'il existe une tâche suivante de la tâche correspondant aux informations de tâche dans un mode correspondant aux informations de mode, d'un signal de commande commandant le module de batterie de sorte que le module de batterie effectue la tâche suivante.

6. Procédé de commande de l'appareil à batterie selon la revendication 5, dans lequel
les informations d'opération incluent en outre des informations sur au moins l'une d'une température et d'une tension d'une cellule de batterie de chacun des modules de batterie,
la transmission des informations d'opération au système de gestion de batterie inclut
la transmission, au système de gestion de batterie, par le module de batterie, d'informations d'opération, incluant des informations de mode indiquant un mode par défaut indiquant qu'aucune opération n'est effectuée par le module de batterie, et
la génération du signal de commande inclut
la génération, par le système de gestion de batterie, d'un signal de commande sur la base d'informations sur au moins l'une d'une température et d'une tension de chacune des cellules de batterie lorsque les informations de mode indiquent le mode par défaut.

7. Procédé de commande de l'appareil à batterie selon la revendication 5 ou 6, dans lequel
la génération du signal de commande inclut
la génération, par le système de gestion de batterie, lorsqu'il détermine qu'il n'existe pas de tâche suivante pour la tâche correspondant aux informations de tâche dans un mode correspondant aux informations de mode, d'un signal de commande commandant le module de batterie de sorte que le module de batterie effectue une première tâche du mode.

8. Procédé de commande de l'appareil à batterie selon l'une quelconque des revendications 5 à 7, dans lequel
le mode inclut au moins l'un d'un mode d'initialisation du système de gestion de batterie, d'un mode d'initialisation du gestionnaire de module de batterie, d'un mode de mesure, d'un mode de diagnostic, d'un mode d'équilibrage des cellules, d'un mode d'erreur et d'un mode par défaut.
